**Europäisches Patentamt**

**European Patent Office**

**Office européen des brevets**

(19)

(11) Publication number: **0 138 254**
**B1**

(12) **EUROPEAN PATENT SPECIFICATION**

(45) Date of publication of patent specification: **01.06.88**

(21) Application number: **84201337.7**

(22) Date of filing: **14.09.84**

(51) Int. Cl.⁴: **H 01 L 21/68, H 02 N 13/00**

(54) Electrostatic chuck and loading method.

(30) Priority: **30.09.83 GB 8326220**
**10.02.84 GB 8403547**

(43) Date of publication of application:
**24.04.85 Bulletin 85/17**

(45) Publication of the grant of the patent:
**01.06.88 Bulletin 88/22**

(84) Designated Contracting States:
**DE FR GB NL**

(56) References cited:
**EP-A-0 074 691**
**WO-A-79/00510**
**FR-A-2 520 930**
**GB-A-1 443 215**
**GB-A-1 501 693**
**GB-A-2 050 064**
**US-A-3 983 401**

**THE REVIEW OF SCIENTIFIC INSTRUMENTS,**
**vol. 44, no. 10, October 1973, New York. G.A.**
**WARDLY: "Electrostatic Wafer huck for**
**Electron Beam Microfabrication", pages 1506-**
**1509**

(73) Proprietor: **PHILIPS ELECTRONIC AND**
**ASSOCIATED INDUSTRIES LIMITED**
**Arundel Great Court 8 Arundel Street**
**London WC2R 3DT (GB)**
㊻ **GB**

(73) Proprietor: **N.V. Philips' Gloeilampenfabrieken**
**Groenewoudseweg 1**
**NL-5621 BA Eindhoven (NL)**
㊻ **DE FR NL**

(72) Inventor: **Ward, Rodney**
**C/O PHILIPS RESEARCH LABORATORIES**
**Redhill Surrey RH1 5HA (GB)**
Inventor: **Lewin, Ian Hale**
**C/O PHILIPS RESEARCH LABORATORIES**
**Redhill Surrey RH1 5HA (GB)**

(74) Representative: **Clark, Jane Anne et al**
**PHILIPS ELECTRONICS Patents and Trade Marks**
**Department Centre Point New Oxford Street**
**London WC1A 1QJ (GB)**

## Description

This invention relates to an electrostatic chuck for holding a semiconductor wafer in intimate contact therewith under the action of Coulombic forces and further relates to a method of loading a semiconductor wafer onto an electrostatic chuck.

In the manufacture of semiconductor devices it is sometimes necessary to clamp a semiconductor wafer substantially flat against a support during certain processing treatments. Such a processing treatment involves directing charged particles towards the wafer. For example, selected areas of the wafer can have their conductivity type modified by the implantation of ions. As another example, an electron sensitive resist may be coated on the wafer surface and the resist can then be exposed to a beam of electrons. For these processing treatments it is known to clamp the semiconductor wafer using an electrostatic chuck in the processing apparatus.

It is noted here that an electrostatic chuck for holding a semiconductor wafer can be used generally for holding a substrate other than a semiconductor wafer having at least some electrically conducting properties.

United Kingdom patent Specification No. 1,443,215 discloses an electrostatic chuck which comprises a layer of dielectric material on an electrically conductive support member. A semiconductor wafer can be located on the chuck so as to bear against the dielectric layer. On applying a potential difference between the wafer and the conductive support member an electrostatic force is set up across the dielectric layer whereby the wafer is clamped substantially flat against the dielectric layer. When the potential difference is not applied the wafer is released and so it can readily be removed from the chuck. For loading and unloading the processing apparatus with the wafer on the chuck it is inconvenient to arrange for the chuck and wafer to remain connected to a voltage source and therefore some other form of retaining means such as mechanical clamps or a lip have to be employed on the chuck. These retaining means can cause the wafer to be distorted leading to irreproducible processing errors.

Moreover, processing treatments involving the use of beams of charged particles as mentioned above are responsible for the generation of thermal energy in the wafer. This thermal energy can cause expansion and distortion of the wafer if the heat generated cannot readily be dissipated. Generally the thermal conductivity of dielectric materials is relatively low. As the wafer is clamped against the dielectric this can act as a barrier to the efficient heat flow from the wafer to the conductive supporting member.

European patent application No. 0074691 discloses an electrostatic chuck with improved thermal conduction from the wafer. This chuck comprises thermally conductive pillars extending through the dielectric layer and engaging the back of the semiconductor wafer. In this case the electrically conductive member has the form of a grid and the thermally conductive pillars extend through the meshes of the grid. The structure of this electrostatic chuck is relatively complex and difficult to make.

According to a first aspect of the present invention there is provided an electrostatic chuck for holding a semiconductor wafer in intimate contact therewith under the action of Coulombic forces, the chuck comprising an electrically conductive member on which is provided a dielectric material layer so that the dielectric material layer extends between the electrically conductive support and a semiconductor wafer when the semiconductor wafer is placed on the chuck, enabling a potential difference to be established between the semiconductor wafer and the electrically conductive member by an applied voltage, the dielectric material layer being loaded with a particulate material of relatively high thermal conductivity providing the layer with an enhanced thermal conductivity to facilitate dissipation of heat from a semiconductor wafer held by the chuck and the dielectric material layer being charge-retaining for holding the semiconductor wafer in intimate contact with the chuck under the action of Coulombic forces after removal of the voltage applied to establish the potential. difference between the semiconductor wafer and the electrically conductive member.

An electrostatic chuck in accordance with the invention enables the advantages of efficient heat dissipation from the wafer to be combined with relative simplicity of structure. The material of the dielectric layer not only has enhanced thermal conduction properties, but also has charge-retaining properties. Thus, in use of an electrostatic chuck embodying the invention, when a semiconductor wafer has been placed on the chuck and a voltage applied by connection to the external voltage source to establish a potential difference between the wafer and the electrically conductive member, the wafer remains held against the chuck even after removal of the applied voltage by disconnection from the voltage source. This is a significant advantage enabling the semiconductor wafer to remain held on the chuck for general handling and particularly for loading and unloading the processing apparatus without the need for the wafer and chuck to remain connected to a voltage source, and without the need for the wafer and chuck to remain connected to a voltage source, and without the need for mechanical retaining means and the attendant disadvantages mentioned above. When located in the processing apparatus, however, a voltage source may be connected across the wafer and chuck to provide even firmer clamping during processing. In order to facilitate connection to the wafer the chuck may comprise means for electrically contacting the semiconductor wafer.

Means may be provided for electrically contacting the semiconductor wafer. In one embodiment of the invention the electrical contact means may be in the form of an electrically conducting annulus which is electrically separate from the electrically conductive member and surrounds the electrically conductive member and the dielectric material layer, the annulus being thicker than the electrically conductive member. Preferably the dielectric layer bonds the annulus and the electrically conductive member together.

The Applicants have found that the dielectric layer of the electrostatic chuck has surprisingly effective charge retention and thermal conduction properties when it comprises epoxy resin loaded with a material, such as particulate alumina or mica, having a relatively high thermal conductivity. With this material the residual charge leaks away slowly allowing a wafer held on the chuck to be released easily after about 24 hours. In order to remove the wafer more immediately the electrostatic chuck may be provided with ducting means, for example one or more apertures extending through the thickness of the dielectric layer and the electrically conductive member, whereby jets of air can be used to release the wafer as described in more detail below.

While the electrostatic chuck is capable of quite satisfactory performance simply by connecting and then disconnecting the external voltage source as described, the Applicants have discovered that the clamping force due only to charge retention in the dielectric (i.e. after disconnecting the external voltage source) tends to be significantly lower than the clamping force which exists when the voltage source is still connected.

According to a second aspect of the present invention, there is provided a method for loading a semiconductor wafer onto an electrostatic chuck in accordance with the first aspect of the invention which method includes the steps of locating the wafer on the dielectric material layer, applying a voltage to establish a potential difference between the semiconductor wafer and the electrically conductive member thereby clamping the wafer to the chuck under the action of Coulombic forces, and subsequently removing the applied voltage, the charge retaining dielectric material layer causing the semiconductor wafer to remain held in intimate contact with the chuck after removal of the applied voltage, which method further comprises displacing the semiconductor wafer on the dielectric material layer at least after applying and before removing the applied voltage.

The Applicants have found that by displacing a wafer held on the chuck while an external voltage source is still connected the residual electrostatic clamping force after disconnecting the voltage source, that is to say the clamping force due to charge retention in the dielectric, can be enhanced several-fold. In fact the Applicants were surprised to find that the residual clamping force immediately after disconnecting the external voltage source may be substantially as strong as if the voltage source were still connected. The wafer may be displaced by separating it from the dielectric layer, by rotating it, by moving it laterally, or a combination of these. This can be achieved manually or mechanically. However, the wafer is less likely to suffer damage if displacement is effected using jets of air directed through ducting means in the chuck. Thus an air jet directed through a single duct orthogonally to the wafer can be used to lift the wafer perpendicularly off the chuck. On the other hand a pair of inclined jets directed respectively through two spaced apart ducts can be used to impart torque and hence rotation to the wafer as well as lifting it from the chuck.

Usually the wafer would be subjected to an initial alignment on the chuck before the external voltage source is connected. In order to preserve this initial alignment as far as possible it is preferable for the wafer to be displaced in an oscillatory manner with a relatively small amplitude of oscillation. A particularly high degree of alignment can be maintained by gradually decreasing the amplitude before the voltage source is disconnected. In this way the wafer returns substantially to its undisturbed, i.e. initially aligned, position before finally being clamped in a specific orientation.

Preferably, the conductive member is shorted to the contact means as the external voltage source is disconnected. This has been found to be beneficial on two counts. Firstly, it appears to promote charge retention in the dielectric resulting in firmer wafer clamping. Secondly, it prevents discharge which would otherwise occur when the loaded chuck is used in a vacuum chamber because the residual gas in the chamber goes through a conductive phase during evacuation. Discharge is undesirable because the residual clamping force is temporarily reduced and consequently the wafer alignment may be disturbed.

An embodiment of the invention will now be described, by way of example, with reference to the accompanying drawing in which

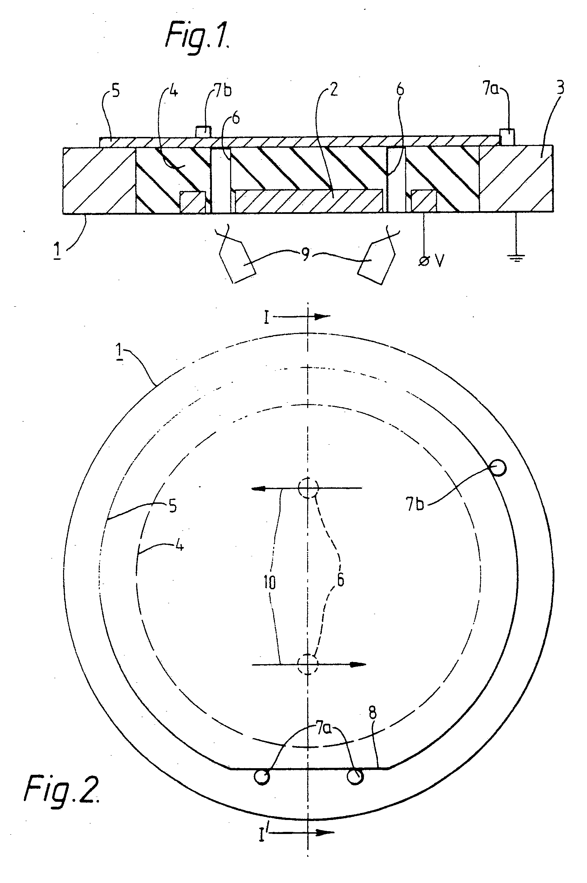

Figure 1 is a cross-section taken on the line I-I' of Figure 2 of a semiconductor wafer loaded on an electrostatic chuck in accordance with the invention, and

Figure 2 is a plan view of the chuck and wafer of Figure 1.

It is noted that, for the sake of clarity, the drawing is not to scale.

The electrostatic chuck 1 comprises an electrically conductive member in the form of a circular aluminium plate 2 which is 92mm in diameter and 5.3mm thick. Plate 2 is surrounded by contact means in the form of an aluminium annulus 3 having an external diameter of 150mm and an internal diameter of 96mm. The thickness of annulus 3 is 5.5mm. Plate 2 is centrally disposed with respect to annulus 3. The space between the plate 2 and the annulus 3 is filled with epoxy resin, in particular Araldite (trade mark), loaded with particulate alumina or mica. A suitable loaded epoxy. is commercially available from Messrs. Emerson and Cuming, Canton, Massachusetts, U.S.A. under the trade mark Stycast 265l. Above the plate 2 the epoxy resin is filled to the level of the annulus 3 to form a dielectric layer 4. The thickness of dielectric layer 4 is approximately 200 micrometres. The upwardly directed surface of the dielectric layer 4 and the annulus 5 is made flat to within approximately ± 5 micrometres by superfinishing.

Ducting means in the form of two 8mm diameter apertures 6 each with a circular cross section and spaced apart by approximately 70mm extend through the full thickness of the dielectric layer 4 and the plate 2. The dielectric layer 4 extends down the flanks of the apertures 6 in the plate 2 to a radial thickness of approximately 0.5mm.

A 101.6mm (4 inch) diameter semiconductor wafer 5 having a conventional flat edge 8 is located centrally on the chuck on the major surface remote from the electrically conductive plate 2. The wafer 5 may be introduced on a cushion of air in known manner. The flat edge 8 of the wafer abuts two location pegs 7a and the curved edge abuts a third location peg 7b provided on the annulus 3. Thus the wafer 5 is initially aligned on the chuck with a specific orientation.

For the major part the wafer 5 rests on the dielectric layer 4, but at the periphery it is contiguous to and hence makes electrical contact with the annulus 3.

After locating the wafer on the chuck 1 as described above, an external voltage source is connected to provide a potential difference V typically of 3.5kV between the annulus 3 and the conductive plate 2. To this end the annulus 3 may be earthed and a voltage source of -3.5kV connected to the plate 2. Because the wafer 5 is in electrical contact with the annulus 3 a potential difference V is established between the wafer 5 and the conductive plate 2 across the dielectric layer 4. This results in the wafer 5 being clamped firmly against the chuck 1 under the action of Coulombic forces.

Before disconnecting the voltage source the wafer 5 is displaced using jets of air from two supply nozzles 9 directed respectively through the two apertures 6 in the chuck 1. The supply nozzles are inclined to the longitudinal axis of the apertures 6, for example by 10°, in order to provide a lateral and a vertical component of force. The inclination of the air jets is such that the lateral components of force are oppositely directed as represented by the arrows 10 so as to impart torque and hence rotation to the wafer. The location pegs 7a, 7b act to restrain the wafer 5 from revolving to any significant extent. Also, the vertical component of force acts to lift the wafer hence separating it from the dielectric layer. The air jets are pulsed at a rate of 1-2/sec. Thus the wafer 5 is displaced in an oscillatory manner both as it rises and falls on the chuck 1 and as it gently rattles in an attempt to revolve against the constraint of the location pegs 7a, 7b. Preferably the force of the air jets is gradually reduced so that the amplitude of oscillation gradually decreases, In this way the wafer 5 is allowed to return to its previously aligned, undisturbed position abutting the location pegs 7a, 7b before finally being clamped in a specific orientation.

The air jet pulsing may continue for approximately 3-4 seconds. When it is stopped the wafer becomes stationary and the external voltage source is disconnected. The wafer 5 remains clamped to the chuck 1 more firmly than it would have been if the wafer had not been displaced while the external voltage source was connected. Thus the wafer can be transported on the chuck without the need for an external voltage source and without the fear that wafer alignment may be lost because of insufficient residual clamping force.

Preferably the conductive plate 2 is shorted to the annulus 3 as the external voltage source is disconnected. As mentioned. previously, this has been found to prevent the chuck discharging in a vacuum chamber. It is desirable that the chuck should be capable of use in a vacuum chamber because it is under vacuum conditions that certain wafer processing treatments, e.g. using electron lithography, are carried out. Under evacuation there is the problem of discharge and the consequential temporary reduction of electrostatic attraction accompanied by the possible loss of wafer alignment. The expedient of discharging the chuck under normal pressure as the voltage source is disconnected not only avoids this problem but also appears to promote charge retention in the dielectric hence optimizing the residual clamping force.

The Applicants have found that the residual charge leaks away slowly allowing the wafer to be removed after about 48 hours. Usually, however, more immediate removal is required. Although mechanical removal is possible it is preferable to use jets of air directed from the back side of the chuck 1, i.e. the side remote from the wafer 5, through the apertures 6 to lift the wafer slightly off the chuck. The wafer 5 can then be floated laterally away from the chuck on a cushion of air directed across the front surface of the chuck or the chuck can be tilted for the wafer simply to slide off.

In the light of the above description it will be evident that many modifications may be made within the scope of the present invention. For example displacement of the wafer may be commenced before the external voltage source is connected. Moreover, if alignment is not critical the wafer may be displaced only by separating it from the dielectric layer without rotation. In this case only a single, vertically directed, air jet may be used which can be ducted through a centrally disposed aperture in the chuck. On the other hand the wafer may be rotated or moved laterally on the chuck without purposely separating it from the dielectric layer. This may be effected mechanically or simply by hand.

As an example of a modification to the construction of the chuck itself, the central conductive plate 2 need not be flush with the back surface of the chuck but instead may be buried in and so fully surrounded by the dielectric material. In this case the conductive plate 2 is contacted by an electrical connection which passes through the dielectric material at the back side of the chuck.

Although the previous description is directed to holding a semiconductor wafer it is noted here that an electrostatic chuck in accordance with the present invention is also suitable for holding other substrates having at least some electrically conducting properties, for example an electrically conductive substrate or an insulating substrate having a conductive or semiconductive coating or surface region.

## Claims

1. An electrostatic chuck for holding a semiconductor wafer in intimate contact therewith under the action of Coulombic forces, the chuck comprising an electrically conductive member on which is provided a dielectric material layer so that the dielectric material layer extends between the electrically conductive support and a semiconductor wafer when the semiconductor wafer is placed on the chuck, enabling a potential difference to be established between the semiconductor wafer and the electrically conductive member by an applied voltage, the dielectric material layer being loaded with a particulate material of relatively high thermal conductivity providing the layer with an enhanced thermal conductivity to facilitate dissipation of heat from a semiconductor wafer held by the chuck and the dielectric material layer being charge-retaining for holding the semiconductor wafer in intimate contact with the chuck under the action of Coulombic forces after removal of the voltage applied to establish the potential difference between the semiconductor wafer and the electrically conductive member.

2. An electrostatic chuck as claimed in Claim 1, further comprising means for electrically contacting the semiconductor wafer.

3. An electrostatic chuck as claimed in Claim 2, wherein the means for electrically contacting the semiconductor wafer is in the form of an electrically conducting annulus which is electrically separate from the electrically conductive member and surrounds the electrically conductive member and the dielectric material layer, the annulus being thicker than the electrically conductive member.

4. An electrostatic chuck as claimed in Claim 2 or 3, wherein the electrically conductive member and the electrical contact means are bonded together in spaced relation by the dielectric layer.

5. An electrostatic chuck as claimed in any of the preceding claims, wherein the dielectric material comprises epoxy resin.

6. An electrostatic chuck as claimed in Claim 5, wherein the epoxy resin is loaded with particulate mica or alumina.

7. An electrostatic chuck as claimed in any of the preceding claims, further comprising ducting means extending through the thickness of the dielectric layer and the electrically conductive member for enabling an air jet to be directed at a semiconductor wafer held by the chuck in order to displace the semiconductor wafer.

8. A method of loading a semiconductor wafer onto an electrostatic chuck as claimed in any one of the preceding claims, which method includes the steps of locating the wafer on the dielectric material layer, applying a voltage to establish a potential difference between the semiconductor wafer and the electrically conductive member thereby clamping the wafer to the chuck under the action of Coulombic forces, and subsequently removing the applied voltage, the charge-retaining dielectric material layer causing the semiconductor wafer to remain held in intimate contact with the chuck after removal of the applied voltage, which method further comprises displacing the semiconductor wafer on the dielectric material layer at least after applying and before removing the applied voltage.

9. A method as claimed in Claim 8, wherein the displacement comprises separating the wafer from the dielectric layer.

10. A method as claimed in Claim 8 or Claim 9, wherein the displacement comprises rotating the wafer.

11. A method as claimed in any of Claims 8 to 10, wherein the displacement comprises moving the wafer laterally on the chuck.

12. A method as claimed in any of Claims 8 to 11, wherein the wafer is displaced in an oscillatory manner.

13. A method as claimed in Claim 12, wherein the amplitude of the oscillatory displacement is gradually decreased before the external voltage source is disconnected.

14. A method as claimed in any of Claims 8 to 13, wherein the displacement is effected by at least one air jet directed at the semiconductor wafer through ducting means in the chuck.

15. A method as claimed in any of Claims 8 to 14, wherein after disconnecting the external voltage source the conductive member is shorted to the semiconductor wafer.

## Patentansprüche

1. Elektrostatische Haltevorrichtung zum Festhalten einer Halbleiterscheibe in gutem Kontakt mit dieser Vorrichtung unter der Einwirkung Coulombscher Kräfte, wobei die Haltevorrichtung ein elektrisch leitendes Element aufweist, auf dem eine dielektrische Materialschicht derart vorgesehen ist, dass die dielektrische Materialschicht sich zwischen dem elektrisch leitenden Träger und einer Halbleiterscheibe erstreckt wenn die Halbleiterscheibe auf die Haltevorrichtung gestellt wird, wobei durch eine zugeführte Spannung ein potentialunterschied zwischen der Halbleiterscheibe und dem elektrisch leitenden Element erzeugt wird, wobei die dielektrische Materialschicht mit einem bestimmten Material einer höheren thermischen Leitfähigkeit belastet wird, wodurch die Schicht eine verbesserte thermische Leitfähigkeit erhält zum Ermöglichen einer Wärmeaufnahme von einer von der Haltevorrichtung festgehaltenen Halbleiterscheibe und wobei die dielektrische Materialschicht die Ladung behält zum Festhalten der Halbleiterscheibe in gutem Kontakt mit der Haltevorrichtung unter Einwirkung von Coulombschen Kräften nach Wegfall der zugeführten Spannung zum Erzeugen des potentialunterschieds zwischen der Halbleiterschicht und dem elektrisch leitenden Element.

2. Elektrostatische Haltevorrichtung nach Anspruch 1 mit weiterhin Mitteln zum elektrischen Kontaktieren der Halbleiterscheibe.

3. Elektrostatische Haltevorrichtung nach Anspruch 2, dadurch gekennzeichnet, dass die Mittel zum elektrischen Kontaktieren der Halbleiterscheibe in Form eines elektrisch leitenden Ringes, der von dem elektrisch leitenden Element getrennt ist und das elektrisch leitende Element sowie die dielektrische Materialschicht umgibt, wobei der Ring dicker ist als das elektrisch leitende Element.

4. Elektrostatische Haltevorrichtung nach Anspruch 2 oder 3, dadurch gekennzeichnet, dass das elektrisch leitende Element und die elektrischen Kontaktmittel unter Zwischenfügung der dielektrischen Schicht zusammengekittet sind.

5. Elektrostatische Haltevorrichtung nach einem der vorstehenden Ansprüche, dadurch gekennzeichnet, dass das dielektrische Material Epoxyharz aufweist.

6. Elektrostatische Haltevorrichtung nach Anspruch 5, dadurch gekennzeichnet, dass das Epoxyharz mit Mika- oder Aluminiumoxidteilchen geladen ist.

7. Elektrostatische Haltevorrichtung nach einem der vorstehenden Ansprüche, weiterhin mit Führungsmitteln, die sich durch die Dicke der dielektrischen Schicht und des elektrisch leitenden Elementes hindurch erstrecken, wodurch ein Luftstrahl auf die durch die Haltevorrichtung festgehaltene Halbleiterscheibe gerichtet werden kann um die Halbleiterscheibe zu verschieben.

8. Verfahren zum Beladen einer elektrostatischen Haltevorrichtung nach einem der vorstehenden Ansprüche mit einer Halbleiterscheibe, wobei diese Verfahren die folgenden Verfahrensschritte aufweist und zwar das Anbringen der Scheibe auf der dielektrischen Materialschicht, das Zuführen einer Spannung zum Erzeugen eines Potentialunterschiedes zwischen der Halbleiterscheibe und dem elektrisch leitenden Element, wodurch die Scheibe unter Einwirkung Coulombscher Kräfte in der Haltevorrichtung eingeklemmt wird und danach das Wegnehmen der zugeführten Spannung, wobei die ladungsbehaltende dielektrische Materialschicht dafür sorgt, dass die Halbleiterscheibe nach dem Wegnehmen der zugeführten Spannung mit der mit der Haltevorrichtung in gutem Kontakt bleibt, wobei dieses Verfahren weiterhin das Verschieben der Halbleiterscheibe auf der dielektrischen Materialschicht wenigstens nach dem Zuführen und vor dem Wegnehmen der zugeführten Spannung umfasst.

9. Verfahren nach Anspruch 8, dadurch gekennzeichnet, dass die Verschiebung das Entfernen der Scheibe von der dielektrischen Schicht bedeutet.

10. Verfahren nach Anspruch 8 oder 9, dadurch gekennzeichnet, dass die Verschiebung das Drehen der Scheibe bedeutet.

11. Verfahren nach einem der Ansprüche 8 bis 10, dadurch gekennzeichnet, dass die Verschiebung das Bewegen der Scheibe in seitlicher Richtung der Haltevorrichtung bedeutet.

12. Verfahren nach einem der Ansprüche 8 bis 11, dadurch gekennzeichnet, dass die Scheibe auf schwingende Weise verschoben wird.

13. Verfahren nach Anspruch 12, dadurch gekennzeichnet, dass die Amplitude der schwingenden Verschiebung allmählich verringert wird bevor die äussere Spannungsquelle entkoppelt wird.

14. Verfahren nach einem der Ansprüche 8 bis 13, dadurch gekennzeichnet, dass die Verschiebung durch wenigstens einen Luftstrahl durchgeführt wird, der durch Führungsmittel in der Haltevorrichtung auf die Halbleiterscheibe gerichtet wird.

15. Verfahren nach einem der Ansprüche 8 bis 14, dadurch gekennzeichnet, dass nach dem Entkoppeln der äusseren Spannungsquelle das leitende Element zu der Halbleiterscheibe kurzgeschlossen wird.

## Revendications

1. Support électro-statique pour maintenir un disque semiconducteur en contact intime avec lui sous l'action de forces de Coulomb, comportant un élément électroconducteur sur lequel est appliquée une couche en un matériau diélectrique de façon que la couche en matériau diélectrique s'étende entre l'élément porteur électroconducteur et un disque semiconducteur lorsque le disque semiconducteur est placé sur le support, permettant d'établir une différence de potentiel entre le disque semiconducteur et l'élément porteur électroconducteur par une tension appliquée, la couche en matériau diélectrique étant chargée de particules d'un matériau d'une conductivité thermique relativement élevée conférant à la couche une conductivité thermique augmentée afin de faciliter la dissipation de chaleur d'un disque semiconducteur maintenu par le support et la couche en matériau diélectrique retenant la charge pour maintenir ledit semiconducteur en contact intime avec le support sous l'action de forces de Coulomb après l'enlèvement de la tension appliquée pour établir les différences en potentiel entre ledit semiconducteur et l'élément électroconducteur.

2. Support électrostatique selon la revendication 1, comportant en outre un moyen pour le contact électrique dudit semiconducteur.

3. Support électrostatique selon la revendication 2, dans lequel le moyen pour le contact électrique avec ledit semiconducteur est sous forme d'un anneau électroconducteur, qui est separé électriquement de l'élément électroconducteur et qui entoure l'élément électroconducteur et la couche en matériau diélectrique, l'anneau étant plus épais que l'élément électroconducteur.

4. Support électrostatique selon la revendication 2 ou 3, dans lequel l'élément électroconducteur et le moyen de contact électrique sont reliés entre eux en relation espacée par la couche diélectrique.

5. Support électrostatique selon l'une des revendications précédentes, dans lequel le matériau diélectrique est constitué par de la résine époxy.

6. Support électrostatique selon la revendication 5, dans lequel la résine époxy est chargée de particules de mica ou d'oxyde d'aluminium.

7. Support électrostatique selon l'une des revendications précédentes, comportant en outre des moyens de conduit s'étendant à travers l'épaisseur de la couche diélectrique et l'élément électroconducteur afin de permettre à un jet d'air d'être dirigé vers un disque semiconducteur maintenu par le support afin de déplacer le disque semiconducteur.

8. Procédé pour charger un disque semiconducteur sur un support électrostatique selon l'une des revendications précédentes, comprenant les étapes de positionnement du disque sur la couche en matériau diélectrique, application d'une tension pour établir une différence de potentiel entre le disque semiconducteur et l'élément électroconducteur, serrage du disque au support sous l'action de forces de Coulomb et puis, enlèvement de la tension appliquée, la couche en matériau diélectrique retenant la charge assurant que le disque semiconducteur est maintenu en contact intime avec le support après enlèvement de la tension appliquée, procédé qui comprend en outre le déplacement de la plaque semiconductrice sur la couche en matériau diélectrique au moins après application et avant enlèvement de la tension appliquée.

9. Procédé selon la revendication 8, selon lequel le déplacement comprend la séparation du disque de la couche diélectrique.

10. Procédé selon la revendication 8 ou la revendication 9, selon lequel le déplacement comprend la rotation du disque.

11. Procédé selon l'une des revendications 8 à 10, selon lequel le déplacement comprend le déplacement latéral du disque sur le support.

12. Procédé selon l'une des revendications 8 à 11, selon lequel le disque est déplacé de façon oscillatoire.

13. Procédé selon la revendication 12, selon lequel l'amplitude du déplacement oscillatoire diminue de façon progressive avant le déclenchement de la source de tension externe.

14. Procédé selon l'une des revendications 8 à 13, selon lequel le déplacement s'effectue par au moins un jet d'air dirigé vers ledit semiconducteur par des moyens de conduit dans le support.

15. Procédé selon l'une des revendications 8 à 14, dans lequel l'élément conducteur est court-circuité par rapport au disque semiconducteur.

Fig.1.

Fig.2.